# EUROPÄISCHE PATENTSCHRIFT

(11) **EP 0 710 806 B1**
(45) Veröffentlichungstag und Bekanntmachung des Hinweises auf die Patenterteilung: **08.01.1997**
(21) Anmeldenummer: 94115609.3
(22) Anmeldetag: 04.10.1994
(51) Int. Cl.: F24J 2/04, H01L 31/048

(54) **Dacheindeckungselement zur Gewinnung elektrischer Energie**
Roofing element for gaining electric energy
Elément de couverture de toit pour l'obtention d'énergie électrique

(43) Veröffentlichungstag der Anmeldung: 08.05.1996
(73) Patentinhaber: Rieter-Werke Händle GmbH & Co. KG, D-78467 Konstanz (DE)
(72) Erfinder: Laumans, Albert Joseph Antoine, Tegelen (NL); Lepsien, Reinhard, Dipl.-Ing., D-78315 Radolfzell (DE); Müller, Heinz, D-78247 Hilzingen (DE)
(74) Vertreter: Liesegang, Roland, Dr.-Ing.

(56) Entgegenhaltungen:
- EP-A- 0 547 285

## Beschreibung

Die Erfindung betrifft ein Dacheindeckungselement gemäß dem Oberbegriff des Anspruchs 1.

Es ist ein solches Dacheindeckungselement bekannt (EP 0 440 103 A2), bei welchem in jeder Längsseite der Mulde je eine langgestreckte, beidendig geschlossene Vertiefung vorgesehen ist und eine insgesamt biegsam ausgebildete Solarzellenplatte unter die beiden Vertiefungen von oben einschnappbar und somit gegen ein Abheben vom Dachziegel nach oben gesichert ist.

Der Erfindung liegt die Aufgabe zugrunde, ein Dacheindeckungselement der im Oberbegriff des Anspruchs 1 angegebenen Art zu schaffen, bei dem eine formschlüssige Halterung zwischen Dachziegel und einem nicht biegsamen Solarzellenelement gegen eine Bewegung in allen Richtungen bei einfacher Montage ermöglicht ist.

Zur Lösung dieser Aufgabe dienen die Merkmale des Anspruchs 1.

Vorteilhafte Ausgestaltungen sind in den Unteransprüchen angegeben.

Bei dem Dacheindeckungselement nach der Erfindung wird die Solarzellenplatte von oben auf dem Dachziegel durch Einschnappen oder Einknipsen der Haltevorsprünge in die geschlossenen Vertiefungen des Dachziegels unter elastischer Verformung der Haltevorsprünge montiert. In gleicher Weise ist die Solarzellenplatte nach Überwinden des durch die Fedrigkeit der Haltevorsprünge gegebenen Widerstandes vom Dachziegel wieder nach oben abhebbar. Dies schafft eine sehr einfache Montage bei gleichzeitiger Gewährleistung einer formschlüssigen Halterung der Solarzellenplatte am Dachziegel, welche nicht nur eine Niederhaltung der Solarzellenplatte sondern auch eine Verschiebung in jedweder Richtung gegenüber dem Dachziegel ausschließt.

Die Erfindung ist im folgenden anhand schematischer Zeichnungen an einem Ausführungsbeispiel mit weiteren Einzelheiten näher erläutert.

Es zeigen:
- Fig. 1: eine Draufsicht auf ein Dacheindeckungselement gemäß der Erfindung;
- Fig. 2: einen Schnitt nach der Linie 2-2 in Fig. 1 und
- Fig. 3: einen vergrößerten Ausschnitt bei III in Fig. 2, wobei die Solarzellenplatte hier weggelassen ist.

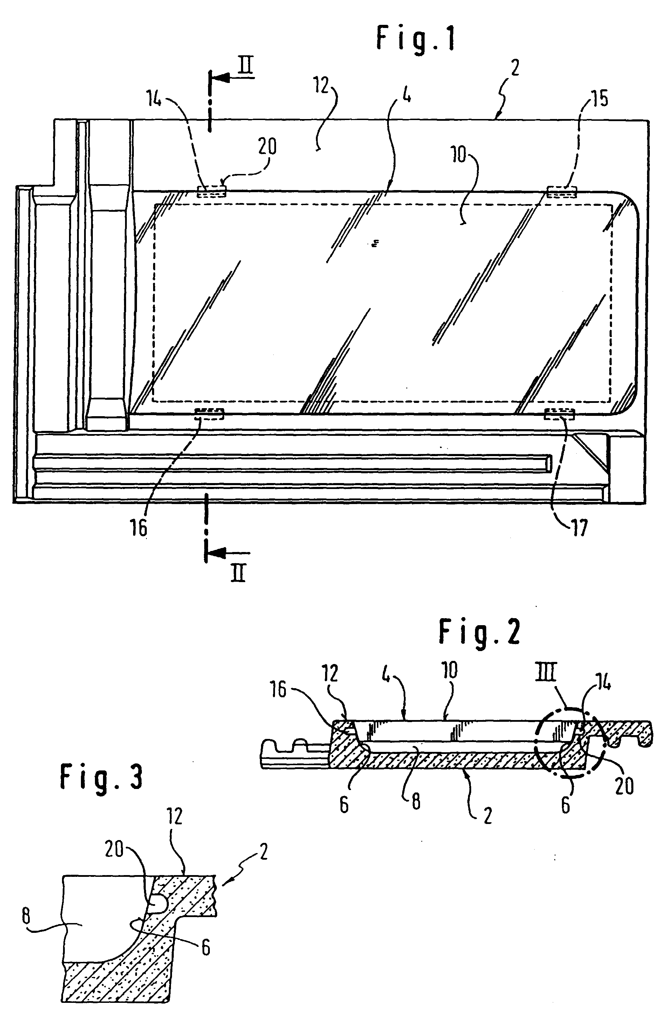

Das gezeigte Dacheindeckungselement weist einen Dachziegel 2 und eine Solarzellenplatte 4 auf. Die Solarzellenplatte 4 liegt mit ihren seitlichen, sich nach unten verjüngenden Rändern an den sich in gleicher Weise verjüngenden inneren Seitenwänden 6 einer in die Oberseite des Dachziegels eingebrachten Mulde 8 so auf, daß die äußere Oberfläche 10 der Solarziegelplatte mit der äußeren Oberfläche 12 des Dachziegels 10 fluchtet. An ihren Längsseiten hat die Solarzellenplatte 4 jeweils zwei im Abstand angeordnete Haltevorsprünge 14, 15, 16, 17, welche jeweils zu zwei Paaren 14, 16 und 15, 17 einander gegenüber stehen. Zur Aufnahme dieser Haltevorsprünge sind entsprechend bemessene, beidendig geschlossene Nuten in den Seitenwänden 6 der Mulde 8 vorgesehen, von denen eine Nut 20 am besten aus Fig. 3 zu erkennen ist.

Aufgrund der Elastizität des Materials der Solarzellenplatte einerseits und der Schrägung der Seitenwände 6 der Mulde 8 andererseits kann die Solarzellenplatte 4 durch Bringen in Position oberhalb der Mulde 8 mit auf die Nuten 20 ausgerichteter Anordnung der Haltevorsprünge 14 bis 17 einfach durch Eindrücken in die Mulde 8 montiert werden, wobei die Haltevorsprünge 14, 15, 16, 17 zunächst elastisch verformt werden und anschließend in die Nuten 20 einrasten. Somit ist eine denkbar einfache Montage und Demontage der Solarzellenplatte 4 im Dachziegel 2 gewährleistet.

In montiertem Zustand, d.h. bei in den Nuten 20 eingerasteten Haltevorsprüngen 14 bis 17, ist die Solarzellenplatte 4 nicht nur gegen ein Abheben vom Dachziegel 2 sondern auch gegen eine Verschiebung in jedweder Richtung der Solarzellenplatte gegenüber dem Dachziegel formschlüssig gehalten.

## Patentansprüche

1. Dacheindeckungselement zur Gewinnung elektrischer Energie aus Sonnenenergie mit einem Dachziegel (2), der eine nach oben freiliegende Mulde (8) mit in gegenüberliegenden Längsseiten (6) der Mulde (8) beidendig geschlossenen Vertiefungen (20) aufweist, in welchen eine Solarzellenplatte (4) lösbar gehalten ist, dadurch **gekennzeichnet**, daß die Vertiefungen (20) auf jeder Länsgseite (16) mit geringer Längserstreckung und im Abstand voneinander zur einschnappenden Aufnahme von federnd nachgiebigen Haltevorsprüngen (14-17) an der Solarzellenplatte (4) vorgesehen sind.

2. Element nach Anspruch 1, dadurch **gekennzeichnet**, daß die Vertiefungen (20) paarweise einander gegenüberliegen.

## Claims

1. A roofing element for obtaining electrical energy from solar energy, comprising a roof tile (2) comprising a trough (8) which is open at the top and which has recesses (20) closed at both ends in opposite longitudinal sides (6) of the trough (8), in which recesses a solar cell plate (4) is releasably held, characterised in that the recesses (20) on each longitudinal side (16) are of a short length and are disposed in spaced relationship so that resiliently flexible retaining projections (14 - 17) on the solar panel (4) can be snapped therein.

2. An element according to claim 1, characterised in that the recesses (20) are situated opposite one another in pairs.

## Revendications

1. Elément de couverture de toit pour la récupération d'une énergie électrique à partir de l'énergie solaire, comportant une tuile (2), qui possède une cavité (8) ouverte vers le haut pourvue de renfoncements (20) fermés à leurs deux extrémités, disposés sur des côtés longitudinaux opposés (6) de la cavité (8) et dans lesquels une plaque (4) de la pile solaire est retenue de façon amovible, caractérisé en ce que les renfoncements (20) sont prévus sur chaque côté longitudinal (16) et possèdent une faible étendue en longueur et sont disposés à distance les uns des autres pour loger, par encliquetage, des parties saillantes flexibles de retenue (14-17) sur la plaque (4) de la pile solaire.

2. Elément selon la revendication 1, caratérisé en ce que les renfoncements (20) sont situés en vis-à-vis par couples.
